(19) Europäisches Patentamt
European Patent Office
Office européen des brevets

(11) Veröffentlichungsnummer: **0 178 594 B1**

(12) **EUROPÄISCHE PATENTSCHRIFT**

(45) Veröffentlichungstag der Patentschrift: **19.06.91**

(51) Int. Cl.5: **G03F 7/38**, G03F 7/022

(21) Anmeldenummer: **85112875.1**

(22) Anmeldetag: **11.10.85**

# (54) Verfahren zum Herstellen negativer Kopien mittels eines Materials auf Basis von 1,2-Chinondiaziden.

(30) Priorität: **15.10.84 DE 3437687**

(43) Veröffentlichungstag der Anmeldung:
**23.04.86 Patentblatt 86/17**

(45) Bekanntmachung des Hinweises auf die Patenterteilung:
**19.06.91 Patentblatt 91/25**

(84) Benannte Vertragsstaaten:
**AT CH DE FR GB IT LI**

(56) Entgegenhaltungen:
**EP-A- 0 141 400**

(73) Patentinhaber: **HOECHST AKTIENGESELLSCHAFT**
**Postfach 80 03 20**
**W-6230 Frankfurt am Main 80(DE)**

(72) Erfinder: **Vollmann, Hansjörg W., Dr. Dipl.-Chem.**
**Am Dachsbau 11**
**W-6232 Bad Soden-Neuenhain(DE)**
Erfinder: **Stahlhofen, Paul, Dr. Dipl.-Chem.**
**Leibnizstrasse 18 b**
**W-6200 Wiesbaden(DE)**

**EP 0 178 594 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung betrifft ein Umkehrverfahren zur Herstellung negativer Kopien mittels eines normalerweise positiv arbeitenden lichtempfindlichen Materials auf Basis von 1,2-Chinondiaziden.

Es ist bekannt, auf Basis von 1,2-Naphthochinondiaziden beruhende positiv arbeitende Reproduktionsmaterialien durch eine bestimmte Folge von Behandlungsschritten negativ zu verarbeiten. In der US-A 3,264,104 ist ein derartiges Umkehrverfahren beschrieben, bei dem die lichtempfindliche Schicht, die bevorzugt thermoplastische Polymere enthält, bildmäßig belichtet, mit einer alkalischen Lösung oder mit Wasser, gegebenenfalls bei erhöhter Temperatur, behandelt wird, ohne die belichteten Stellen auszuwaschen, nochmals ohne Vorlage ganzflächig belichtet und dann wie üblich entwickelt wird, wobei die ursprünglich bildmäßig belichteten Stellen stehenbleiben und die übrigen Stellen ausgewaschen werden.

Dieses Verfahren hat den Nachteil, daß es eine verhältnismäßig große Zahl von Behandlungsschritten erfordert, daß die erste Alkalibehandlung stets mit besonderer Sorgfalt erfolgen muß, um möglichst wenig von der in wäßrigem Alkali löslichen belichteten Schicht abzulösen, und daß es den Zusatz von in Alkali schwerlöslichen Polymeren erfordert, die die Verwendbarkeit des Materials für andere Zwecke einschränken.

Aus der EP-A 0 024 916 ist für die Herstellung von Resistschichten ein ähnliches Umkehrverfahren bekannt, bei dem ein Material auf Basis von 1,2-Chinondiaziden nach bildmäßiger Belichtung erhitzt, dann ohne Vorlage nachbelichtet und mit wäßrigem Alkali zum Negativ entwickelt wird. Das Material enthält in der lichtempfindlichen Schicht bestimmte photochrome Verbindungen, die beim Erwärmen mit den Lichtreaktionsprodukten des Chinondiazids reagieren und zu einer Schichthärtung führen sollen. Dieses Material ist an die Anwesenheit von photochromen Substanzen gebunden, deren Lichtreaktion eine bei manchen Anwendungen störende Verfärbung ergibt.

In der GB-A 2.082.339 wird ein lichtempfindliches Gemisch, bestehend aus einem o-Chinondiazid und mindestens einem Resol, für die Herstellung einer lithographischen Druckplatte beschrieben, die ebenfalls sowohl positiv als auch negativ verarbeitet werden kann. Dieses Umkehrverfahren enthält die gleiche Folge von Schritten wie das zuvor genannte. Seine Wirkung beruht darauf, daß die Lichtzersetzungsprodukte des o-Chinondiazids mit dem Resol in der Wärme ein unlösliches Reaktionsprodukt ergeben. Von Nachteil ist die relativ mangelhafte Lagerfähigkeit dieser Druckplatten infolge der Eigenhärtung von Resolen.

In den DE-A 28 55 723 und 25 29 054 (entsprechend US-A 4,104,070) werden Resistschichten auf Basis von 1,2-Chinondiaziden für ein Umkehrverfahren beschrieben, die als Zusatz zur thermischen Schichthärtung N-Acyl-N'-methylol-ethylendiamine oder Hydroxyethylimidazole enthalten. Ein ähnliches Material mit einem Gehalt an sekundären oder tertiären Aminen wird in der US-A 4,196,003 beschrieben.

In DE-A 33 25 022 wird ein Umkehrverfahren auf Basis von 1,2-Chinondiaziden vorgeschlagen, bei dem das lichtempfindliche Material als Zusatz zur thermischen Schichthärtung einen Ether des Hexamethylolmelamins enthält.

Derartige Zusätze mit basischen Gruppen haben im allgemeinen einen nachteiligen Einfluß auf den Bildkontrast nach dem Belichten, vor allem dann, wenn die Abnahme bzw. Änderung der Farbintensität durch bestimmte beim Belichten entstehende saure Produkte und/oder freie Rakikale in Verbindung mit einem gegenüber Säuren und/ oder freien Rakikalen empfindlichen Farbstoff hervorgerufen wird.

Derartige Zusätze haben jedoch im allgemeinen einen nachteiligen Einfluß auf die Lagerfähigkeit der Kopierschichten und auf bestimmte kopiertechnische Eigenschaften, z.B. die Lichtempfindlichkeit und den Bildkontrast nach dem Belichten. Auch ist für viele Anwendungszwecke die zur Bildumkehr erforderliche Temperatur zu hoch, oder die Dauer des Erhitzens bei niedrigerer Temperatur ist zu lang.

Aufgabe der Erfindung war es, ein Umkehrverfahren zur Herstellung negativer Kopien mittels eines normalerweise positiv arbeitenden lichtempfindlichen Materials auf Basis von 1,2-Chinondiaziden zu schaffen, das keine Zusätze zur Kopierschicht erfordert, die deren Lagerfähigkeit und Bildkontrast nach dem Belichten beeinträchtigen, und das nur kurzzeitiges Erwärmen auf relativ niedrige Temperaturen erfordert, um eine thermische Härtung der belichteten Schichtbereiche zu ermöglichen.

Gegenstand der Erfindung ist ein Verfahren zum Herstellen von negativen Reliefkopien, bei dem ein lichtempfindliches Material aus einem Schichtträger und einer lichtempfindlichen Schicht, die als wesentliche Bestandteile eine die thermische Härtung fördernde Verbindung und ein 1,2-Chinondiazid enthält, bildmäßig belichtet, danach erwärmt, nach dem Abkühlen nochmals ganzflächig belichtet und dann mittels eines wäßrigalkalischen Entwicklers entwickelt wird.

Das erfindungsgemäße Verfahren ist dadurch gekennzeichnet, daß die lichtempfindliche Schicht als die thermische Härtung fördernde Verbindung mindestens eine quartäre Phosphoniumverbindung der allgemeinen Formel

$$[(R)_3-\overset{+}{P}-R'] \overset{-}{Hal}$$

worin R und R' gleich oder verschieden sind und Alkyl oder Aryl und Hal Halogen bedeuten, enthält. Vorzugsweise bedeuten R und R' Alkyl oder Alkenyl mit 1 bis 4 Kohlenstoffatomen bzw. gegebenenfalls substituiertes Phenyl und Hal Chlor oder Brom. Ganz besonders bevorzugt sind Verbindungen, wie Tetramethylphosphoniumchlorid, Tetrabutylphosphoniumbromid oder Tetraphenylphosphoniumbromid.

Die Darstellung der Phosphoniumverbindungen erfolgt durch Alkylierung bzw. Arylierung tertiärer Phosphine. Die verschiedenen Methoden zur Herstellung sind in "Methoden der organischen Chemie" (Houben-Weyl) Band XII/1 (1963), Seiten 79 bis 104, aufgeführt.

Brauchbare Sensibilisatoren, die gemäß der Erfindung verwendet werden können, sind alle 1,2-Chinondiazidsulfonsäureester und -amide, 1,2-Chinondiazid-carbonsäureester und -amide, die nach dem Bestrahlen mit aktinischem Licht in wäßrig-alkalischen Lösungen löslich werden. Hierzu zählen die Umsetzungsprodukte von 1,2-Benzo-oder 1,2-Naphthochinondiazid-4- oder -5-sulfonsäure bzw. von deren Säurechloriden mit Phenol-Aldehyd/ Aceton-Kondensationsprodukten oder Polymeren aus p-Hydroxystyrol, p-Aminostyrol oder Copolymeren dieser beiden Verbindungen.

Die Ester und Amide der 1,2-Chinondiazid-4-sulfonsäuren und der -4-carbonsäuren werden mit besonderem Vorteil verwendet, da sie bereits ohne Zusatz von quartären Phosphoniumverbindungen bei der beschriebenen Verarbeitung eine Umkehrwirkung ergeben. Beim Einsatz dieser Verbindungen ist es deshalb möglich, entweder die Menge an quartären Phosphoniumverbindungen oder die Dauer oder die Temperatur des Erhitzens herabzusetzen.

Als Ester der 1,2-Chinondiazidderivate kommen die bekannten Umsetzungsprodukte der Säuren oder ihrer Halogenide mit Phenolen, insbesondere mehrwertigen Phenolen, in Betracht, z.B. mit 2,3,4-Trihydroxybenzophenon, 2,4-Dihydroxy-benzophenon, 4-Decanoyl-resorcin, 4-(2-Phenylprop-2-yl)phenol, Gallussäureoctylester, oder 4,4-Bis-(4-hydroxyphenyl)valeriansäurebutylester. Die Amide können in bekannter Weise von längerkettigen aliphatischen oder bevorzugt aromatischen Aminen abgeleitet sein.

Die Menge an o-Chinondiazidverbindungen beträgt im allgemeinen 3 bis 50, bevorzugt 7 bis 35 Gew.-%, bezogen auf die nichtflüchtigen Anteile der lichtempfindlichen Schicht.

Die Konzentration der quartären Phosphoniumverbindung in dem lichtempfindlichen Gemisch kann in relativ weiten Grenzen schwanken. Im allgemeinen liegt der Anteil bei 1 bis 50, vorzugsweise zwischen 3 und 30 Gew.-%, bezogen auf das Gewicht der nichtflüchtigen Bestandteile der lichtempfindlichen Schicht.

Die lichtempfindliche Schicht enthält ferner vorzugsweise ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Bindemittel auch bei dem erfindungsgemäßen Verfahren als vorteilhaft erwiesen. Die Novolake können auch in bekannter Weise durch Umsetzung eines Teils ihrer Hydroxygruppen, z.B. mit Chloressigsäure, Isocyanaten, Epoxiden oder Carbonsäureanhydriden, modifiziert sein. Als weitere alkalilösliche bzw. in Alkali quellbare Bindemittel werden Polyhydroxyphenylharze, die durch Kondensation aus Phenolen und Aldehyden oder Ketonen hergestellt werden, Mischpolymerisate aus Styrol und Maleinsäureanhydrid, Polyvinylphenole oder Mischpolymerisate der Acrylsäure oder Methacrylsäure, insbesondere mit Acryl- oder Methacrylsäureestern, bevorzugt. Die Art und Menge des alkalilöslichen Harzes kann je nach Anwendungszweck verschieden sein; bevorzugt werden Anteile am Gesamtfeststoff zwischen 90 und 30, besonders vorzugt 85 bis 55 Gew.-%.

Zusätzlich können noch zahlreiche andere Harze mitverwendet werden, bevorzugt Epoxyharze und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate. Der günstigste Anteil an diesen Harzen richtet sich nach den anwendungstechnischen Erfordernissen und dem Einfluß auf die Entwicklungsbedingungen und beträgt im allgemeinen nicht mehr als 50 Gew.-%, bevorzugt etwa 2 bis 35 Gew.-%, vom alkalilöslichen Harz. In geringen Mengen kann die lichtempfindliche Schicht für spezielle Erfordernisse wie Flexibilität, Haftung, Glanz und Färbung, außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Ferner können der lichtempfindlichen Schicht für den Farbumschlag nach dem Belichten noch geringe Mengen von strahlungsempfindlichen Komponenten beigefügt werden, die beim Belichten vorzugsweise

starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinondiazid-4-sulfonsäurechlorid, chromophor substituierte Halogenmethyl-s-triazine oder Diazoniumverbindungen in Form ihrer Salze mit komplexen Säuren wie Borfluorwasserstoffsäure oder Hexafluorphosphorsäure.

Zur Beschichtung eines geeigneten Schichtträgers werden die Bestandteile im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether werden besonders bevorzugt.

Als Schichtträger für Schichtdicken unter ca. 10 $\mu$m werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolysiertem Tetraethylorthosilikat, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Belichtet wird mit den in der Technik üblichen Lichtquellen. Auch das Bestrahlen mit Elektronen oder Lasern stellt eine Möglichkeit zur Bebilderung dar.

Zum Entwickeln werden wäßrig-alkalische Lösungen abgestufter Alkalität verwendet, vorzugsweise mit einem pH im Bereich von 10 bis 14, die auch kleinere Mengen organischer Lösungs- oder Netzmittel enthalten können.

Nach dem bildmäßigen Bestrahlen bzw. Belichten wird das Material ohne weitere Zwischenbehandlung erwärmt. Das Erwärmen kann durch Bestrahlung, Konvektion, durch Kontakt mit erwärmten Flächen, z.B. Walzen, oder durch Tauchen in ein erwärmtes Bad einer inerten Flüssigkeit, z.B. Wasser, erfolgen. Die Temperatur kann zwischen 70 und 150, vorzugsweise bei 90 bis 130 °C liegen. Derartige Temperaturen werden von den Gemischen vertragen, ohne daß die Eigenschaften der unbelichteten Bereiche wesentlich verändert werden. Die Dauer des Erwärmens kann je nach Art der Wärmeeinwirkung sehr unterschiedlich sein. Bei Übertragung durch ein Wärmemedium liegt sie im allgemeinen zwischen 10 Sekunden und 10 Minuten, vorzugsweise zwischen 30 Sekunden und 4 Minuten.

Nach dem Erwärmen und Abkühlen wird die lichtempfindliche Schicht ohne Vorlage einer ganzflächigen Belichtung unterworfen, um die noch lichtempfindlichen Schichtbereiche vollständig in ihre Lichtzersetzungsprodukte umzuwandeln. Die Nachbelichtung kann vorteilhaft unter der gleichen Lichtquelle erfolgen, die zur Bildbelichtung verwendet wurde.

An die Nachbelichtung schließt sich eine Entwicklung mit üblichen Entwicklern an, wobei die Schichtbereiche ausgewaschen werden, die bei der ursprünglichen Bildbelichtung nicht vom Licht getroffen waren. Als Entwickler sind vorzugsweise wäßrige Lösungen von alkalischen Substanzen, z.B. von Alkaliphosphaten, -silikaten, -carbonaten oder -hydroxiden geeignet, die ferner Netzmittel oder kleinere Mengen organischer Lösungsmittel enthalten können. In bestimmten Fällen sind auch organische Lösungsmittel oder Gemische derselben mit Wasser als Entwickler geeignet. Die Entwicklung kann unmittelbar nach dem Erwärmen und Abkühlen oder auch in zeitlichem Abstand von z.B. mehreren Stunden erfolgen, ohne daß die gehärteten Schichtbereiche angegriffen werden. Daraus ist zu schließen, daß die Schichthärtung der belichteten Stellen durch Erwärmen irreversibel ist.

Das erfindungsgemäße Verfahren hat den Vorteil gegenüber den bekannten Umkehrverfahren, daß bei guter Lagerfähigkeit der Kopierschichten die Aushärtung der bildmäßig belichteten Schichtbereiche bei erhöhter Temperatur relativ schnell erfolgt und daß die Temperatur des für den Umkehrschritt erforderlichen Temperns relativ niedrig und die Verweilzeit bei erhöhter Temperatur relativ kurz ist.

Vorteilhaft ist ferner, daß durch den erfindungsgemäßen Zusatz der quartären Phosphoniumverbindungen der Bildkontrast nach dem Belichten nicht nachteilig beeinflußt wird.

Das erfindungsgemäße Verfahren kann z.B. zur Herstellung von Druckformen für den Hoch-, Tief- und Flachdruck sowie von Photoresistschablonen für die subtraktive und additive Leiterplattenherstellung, für die galvanische Herstellung von Nickelrotationszylindern oder für die Maskenherstellung in der Mikroelektronik nach der Lift-off-Technik eingesetzt werden.

Die folgenden Beispiele beschreiben bevorzugte Ausführungsformen des erfindungsgemäßen Verfahrens. Prozentzahlen und Mengenverhältnisse sind, wenn nichts anderes angegeben ist, in Gewichtseinheiten zu verstehen.

Beispiel 1

Mit einer Lösung von

| | | |
|---|---|---|
| 2,00 | Gt | des Veresterungsproduktes aus 1 mol 2,3,4-Trihydroxy-benzophenon und 3 mol Naphthochinon-1,2-diazid-(2)-5-sulfonsäurechlorid, |
| 7,00 | Gt | eines Kresol-Formaldehyd-Novolaks mit einem Erweichungspunkt von 105 bis 120 °C nach Kapillarmethode DIN 53 181, |
| 0,150 | Gt | 2-(4-Ethoxy-naphth-1-yl)-4,6-bis-trichlormethyl-s-triazin, |
| 1,00 | Gt | Tetrabutylphosphoniumbrom'd und |
| 0,060 | Gt | Kristallviolett in |
| 60,00 | Gt | Ethylenglykolmonomethylether und |
| 60,00 | Gt | Tetrahydrofuran |

wurde eine elektrochemisch aufgerauhte und anodisierte Aluminiumplatte beschichtet, die mit einer wäßrigen Lösung von 0,1 Gewichtsprozent Polyvinylphosphonsäure behandelt worden war, wie es in der DE-PS 16 21 478 beschrieben ist.

Das so hergestellte vorsensibilisierte Material mit einem Schichtgewicht von 2,3 g/$m^2$ wurde durch ein Diapositiv unter einer 5 kW-Metallhalogenidlampe im Abstand von 110 cm 65 Sekunden belichtet und anschließend mit einer 10 %igen wäßrigen Lösung von Natriummetasilikat entwickelt. Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt. Durch Einfärben mit Fettfarbe wurde eine druckfertige Positiv-Druckform erhalten.

Eine andere Probe des gleichen vorsensibilisierten Materials wurde als Negativ-Druckplatte verarbeitet. Zu diesem Zweck wurde die Probe unter einer negativen Vorlage 90 Sekunden belichtet, anschließend 2 Minuten auf 130 °C erwärmt und dann ohne Vorlage dieselbe Zeit wie bei der bildmäßigen Positiv-Belichtung ganzflächig nachbelichtet. Beim Entwickeln mit dem gleichen Entwickler entstand das Umkehrbild der Vorlage.

Sowohl die Positiv-Druckform als auch die Negativ-Druckform läßt sich bei Temperaturen oberhalb 180 °C einbrennen, wodurch die Auflagenleistung um ein Mehrfaches gesteigert werden kann.

Mit einer nach diesem Beispiel hergestellten Druckplatte, die jedoch nicht den Zusatz von Tetrabutylphosphoniumbromid enthielt, resultierte nach der bildmäßigen Belichtung und Entwicklung nur eine der verwendeten Vorlage entsprechende Druckform. Ohne den Zusatz von Tetrabutylphosphoniumbromid ist es nicht möglich, nach der gleichen Methode wie oben beschrieben, aus dem vorsensibilisierten positiv arbeitenden Material nach dem erfindungsgemäß beschriebenen Verfahren brauchbare Negativ-Kopien zu erhalten.

Beispiel 2

Mit einer Lösung von

| | | |
|---|---|---|
| 2,00 | Gt | des Veresterungsproduktes aus 1 mol 4-(2-Phenyl-prop-2-yl)-phenol und 1 mol Naphthochinon-(1,2)-diazid-(2)-4-sulfonsäurechlorid, |
| 6,00 | Gt | des in Beispiel 1 angegebenen Kresol-Formaldehyd-Novolaks, |
| 0,20 | Gt | Naphthochinon-(1,2)-diazid-(2)-4-sulfonsäurechlorid, |
| 2,00 | Gt | Tetrabutylphosphoniumbromid und |
| 0,06 | Gt | Kristallviolett in |
| 50,00 | Gt | Ethylenglykolmonomethylether und |
| 60,00 | Gt | Tetrahydrofuran |

wurde eine elektrochemisch aufgeraute und anodisierte Aluminiumplatte beschichtet, die mit einer wäßrigen Lösung von 0,1 Gew.-% Polyvinylphosphonsäure behandelt worden war.

Das so hergestellte vorsensibilisierte Material mit einem Schichtgewicht von 2,4 g/m$^2$ wurde, wie in Beispiel 1 beschrieben, unter einer transparenten Positiv-Vorlage 50 Sekunden lang bildmäßig belichtet und anschließend mit einer 10 %igen Natriummetasilikat-Lösung entwickelt, wodurch eine der Vorlage entsprechende positive Druckschablone erhalten wurde.

Eine andere Probe des gleichen Materials wurde als Negativ-Druckplatte verarbeitet, indem unter einer negativen Vorlage 50 Sekunden lang belichtet, anschließend 2 Minuten auf 120 °C erwärmt und ohne Vorlage dieselbe Zeit wie bei der bildmäßigen Belichtung nachbelichtet wurde. Beim Entwickeln mit dem gleichen Entwickler entstand das Umkehrbild der Vorlage.

Beispiel 3

Mit einer Lösung von

| | | |
|---|---|---|
| 2,00 | Gt | des Veresterungsproduktes aus 1 mol des Ethoxyethylesters der 4,4-Bis-(4-hydroxyphenyl)-n-valeriansäure und 2 mol Naphthochinon-(1,2)-diazid-(2)-5-sulfonsäurechlorid, |
| 7,00 | Gt | des in Beispiel 1 angegebenen Kresol-Formaldehyd-Novolaks, |
| 0,15 | Gt | 2,4-Bis-(trichlormethyl)-6-styryl-s-triazin, |
| 1,00 | Gt | Tetrabutylphosphoniumbromid und |
| 0,07 | Gt | Kristallviolett in |
| 50,00 | Gt | Ethylenglykolmonomethylether und |
| 60,00 | Gt | Tetrahydrofuran |

wurde eine elektrochemisch aufgerauhte und anodisierte Aluminiumplatte beschichtet.

Das so hergestellte Material mit einem Schichtgewicht von 2,50 g/m$^2$ der lichtempfindlichen Schicht wurde, wie in Beispiel 1 beschrieben, unter einer transparenten Positiv-Vorlage 50 Sekunden lang bildmäßig belichtet und anschließend mit einer 10 %igen Natriummetasilikat-Lösung entwickelt, wodurch eine der Vorlage entsprechende positive Druckschablone erhalten wurde.

Eine andere Probe des gleichen Materials wurde als Negativ-Druckplatte verarbeitet, indem unter einer Negativ-Vorlage 100 Sekunden lang belichtet, anschließend 2 Minuten auf 130 °C erwärmt und dann ohne Vorlage dieselbe Zeit wie bei der bildmäßigen Positiv-Belichtung nachbelichtet wurde. Beim Entwickeln mit dem gleichen Entwickler entstand das Umkehrbild der Vorlage.

Beispiel 4

Mit einer Lösung von

| | | |
|---|---|---|
| 1,30 | Gt | des Veresterungsproduktes aus 1 mol 4-(2-Phenyl-prop-2-yl)-phenol und 1 mol Naphthochinon-(1,2)-diazid-(2)-4-sulfonsäurechlorid, |
| 8,60 | Gt | des in Beispiel 1 angegebenen Kresol-Formaldehyd-Novolaks, |
| 0,14 | Gt | 2,4-Bis-(trichlormethyl)-6-p-methoxy-styryl-s-triazin, |
| 0,15 | Gt | Tetrabutylphosphoniumbromid und |
| 0,07 | Gt | Kristallviolett in |
| 50,00 | Gt | Ethylenglykolmonomethylether und |
| 60,00 | Gt | Tetrahydrofuran |

wurde eine elektrochemisch aufgerauhte und anodisierte Aluminiumplatte bechichtet, die mit einer wäßrigen Lösung von 0,1 Gew.-% Polyvinylphosphonsäure behandelt worden war.

Das so hergestellte vorsensibilisierte Material mit einem Schichtgewicht von 2,70 g/m$^2$ wurde, wie in Beispiel 1 beschrieben, 40 Sekunden lang unter einer transparenten Positiv-Vorlage belichtet und anschließend mit einer 10 %igen Natriummetasilikat-Lösung entwickelt. Es entstand eine der Vorlage entsprechende positive Druckschablone.

Eine andere Probe des gleichen Materials wurde als Negativ-Druckplatte verarbeitet. Zu diesem Zweck wurde die Probe unter einer negativen Vorlage 80 Sekunden belichtet, anschließend 2 Minuten auf 130 °C erwärmt und dann ohne Vorlage nochmals 40 Sekunden nachbelichtet. Nach der Entwicklung resultierte das Umkehrbild der Vorlage.

Beispiel 5

Mit einer Lösung von

| | | |
|---|---|---|
| 2,00 | Gt | des Veresterungsproduktes aus 1 mol |

| | | |
|---|---|---|
| | | 2,3,4-Trihydroxybenzophenon und 3 mol Naphthochinon-(1,2)-diazid-(2)-5-sulfonsäurechlorid, |
| 6,00 | Gt | eines Phenol-Formaldehyd-Novolak-Harzes vom Schmelzintervall 83 bis 88 °C, |
| 0,15 | Gt | 2,4-Bis-(trichlormethyl)-6-styryl-s-triazin, |
| 2,00 | Gt | Tetraphenylphosphoniumbromid und |
| 0,06 | Gt | Kristallviolett in |
| 60,00 | Gt | Ethylenglykolmonomethylether und |
| 70,00 | Gt | Tetrahydrofuran |

wurde eine elektrochemisch aufgerauhte und anodisierte Aluminiumplatte beschichtet, die mit einer wäßrigen Lösung von 0,1 Gew.-% Polyvinylphosphonsäure behandelt worden war.

Das so hergestellte vorsensibilisierte Material mit einem Schichtgewicht von 2,30 g/m$^2$ wurde, wie in Beispiel 1 beschrieben, 45 Sekunden lang unter einer transparenten Positiv-Vorlage belichtet und anschließend mit einer 3 %igen Natriummetasilikat-Lösung aufentwickelt. Hierbei entstand eine der Vorlage entsprechende Druckschablone.

Zur Verarbeitung als Negativ-Druckplatte wurde eine andere Probe des Materials 90 Sekunden unter einer Negativ-Vorlage belichtet, anschließend 2 Minuten auf 130 °C erwärmt und dann ohne Vorlage nochmals 45 Sekunden nachbelichtet. Beim Entwickeln mit dem gleichen Entwickler entstand das Umkehrbild der Vorlage.

Beispiel 6

Mit einer Lösung von

| | | |
|---|---|---|
| 2,00 | Gt | des Veresterungsproduktes aus 1 mol 2,3,4-Trihydroxybenzophenon und 3 mol Naphthochinon-(1,2)-diazid-(2)-5-sulfonsäurechlorid, |
| 8,00 | Gt | des in Beispiel 1 angegebenen Kresol-Formaldehyd-Novolaks, |
| 0,15 | Gt | 2-(4-Ethoxy-naphth-1-yl)-4,6-bis-trichlormethyl-s-triazin, |
| 1,50 | Gt | Tetrabutylphosphoniumbromid und |
| 0,06 | Gt | Kristallviolett in |
| 60,00 | Gt | Ethylenglykolmonomethylether und |
| 70,00 | Gt | Tetrahydrofuran |

wurde eine elektrochemisch aufgerauhte und anodisierte Aluminiumplatte beschichtet, die mit einer wäßrigen Lösung von 0,1 Gew.-% Polyvinylphosphonsäure behandelt worden war.

Das so hergestellte vorsensibilisierte Material mit einem Schichtgewicht von 2,4 g/m$^2$ wurde, wie in Beispiel 1 beschrieben, 65 Sekunden lang unter einer transparenten Positiv-Vorlage belichtet und anschließend mit einer 10 %igen Natriummetasilikat-Lösung entwickelt. Es entstand eine der Vorlage entsprechende Druckschablone.

Zur Verarbeitung als Negativ-Druckplatte wurde eine andere Probe des gleichen vorsensibilisierten Materials 65 Sekunden unter einer Negativ-Vorlage belichtet, anschließend 2 Minuten auf 130 °C erwärmt und dann ohne Vorlage nochmals 65 Sekunden nachbelichtet. Beim Entwickeln mit dem gleichen Entwickler entstand das Umkehrbild der Vorlage.

Beispiel 7

Mit einer Lösung von

| | | |
|---|---|---|
| 2,00 | Gt | des Veresterungsproduktes aus 1 mol 4-(2-Phenyl-prop-2-yl)-phenol und 1 mol Naphthochinon-(1,2)-diazid-(2)-4-sulfonsäurechlorid, |
| 5,00 | Gt | des in Beispiel 5 angegebenen Phenol-Formaldehyd-Novolaks, |
| 0,15 | Gt | 2,4-Bis-(trichlormethyl)-6-styryl-s-triazin, |
| 1,00 | Gt | Tetraphenylphosphoniumbromid und |
| 0,06 | Gt | Kristallviolett in |
| 60,00 | Gt | Ethylenglykolmonomethylether und |
| 60,00 | Gt | Tetrahydrofuran |

wurde eine elektrochemisch aufgerauhte und anodisierte Aluminiumplatte beschichtet, die mit einer wäßrigen Lösung von 0,1 Gew.-% Polyvinylphosphonsäure behandelt worden war.

Das so hergestellte vorsensibilisierte Material mit einem Schichtgewicht von 2,30 $g/m^2$ wurde, wie in Beispiel 1 beschrieben, 45 Sekunden lang unter einer transparenten Positiv-Vorlage belichtet und anschließend mit einer 2 %igen Natriummetasilikat-Lösung aufentwickelt. Hierbei entstand eine der Vorlage entsprechende Druckschablone.

Zur Verarbeitung als Negativ-Druckplatte wurde eine andere Probe des Materials 90 Sekunden unter einer Negativ-Vorlage belichtet, anschließend 2 Minuten auf 130 °C erwärmt und dann ohne Vorlage nochmals 45 Sekunden nachbelichtet. Beim Entwickeln mit dem gleichen Entwickler entstand das Umkehrbild der Vorlage.

Beispiel 8

Mit einer Lösung von

| | | |
|---|---|---|
| 2,00 | Gt | des Veresterungsproduktes aus 1 mol 2,3,4-Trihydroxybenzophenon und 3 mol Naphthochinon-(1,2)-diazid-(2)-5-sulfonsäurechlorid, |
| 7,00 | Gt | eines Kresol-Formaldehyd-Novolaks wie in Beispiel 1 angegeben, |
| 0,150 | Gt | 2,4-Bis-(trichlormethyl)-6-styryl-s-triazin, |
| 1,00 | Gt | Tetramethylphosphoniumchlorid und |
| 0,060 | Gt | Kristallviolett in |
| 60,00 | Gt | Ethylenglykolmonomethylether und |
| 60,00 | Gt | Tetrahydrofuran |

wurde eine elektrochemisch aufgerauhte und anodisierte Aluminiumplatte beschichtet.

Das so hergestellte vorsensibilisierte Material mit einem Schichtgewicht von 2,3 $g/m^2$ wurde durch ein Diapositiv unter einer 5 kW-Metallhalogenidlampe im Abstand von 110 cm 65 Sekunden belichtet und anschließend mit einer 9 %igen wäßrigen Lösung von Natriummetasilikat entwickelt. Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt. Durch Einfärben mit Fettfarbe wurde eine druckfertige Positiv-Druckform erhalten.

Eine andere Probe des gleichen vorsensibilisierten Materials wurde als Negativ-Druckplatte verarbeitet. Zu diesem Zweck wurde die Probe unter einer negativen Vorlage 90 Sekunden belichtet, anschließend 2 Minuten auf 130 °C erwärmt und dann ohne Vorlage dieselbe Zeit wie bei der bildmäßigen Positiv-Belichtung nachbelichtet. Beim Entwickeln mit dem gleichen Entwickler entstand das Umkehrbild der Vorlage.

**Ansprüche**

1. Verfahren zum Herstellen von negativen Reliefkopien, bei dem ein lichtempfindliches Material aus einem Schichtträger und einer lichtempfindlichen Schicht, die als wesentliche Bestandteile eine die thermische Härtung fördernde Verbindung und ein 1,2-Chinondiazid enthält, bildmäßig belichtet, danach erwärmt, nach dem Abkühlen nochmals ganzflächig belichtet und dann mittels eines wäßrig-alkalischen Entwicklers entwickelt wird, dadurch gekennzeichnet, daß die lichtempfindliche Schicht als die thermische Härtung fördernde Verbindung mindestens eine quartäre Phosphoniumverbindung der allgemeinen Formel

$$[(R)_3\text{-}\overset{+}{P}\text{-}R']\ \overset{-}{Hal}$$

worin R und R' gleich oder verschieden sind und Alkyl, Alkenyl oder Aryl und Hal Halogen bedeuten, enthält.

2. Verfahren nach Anspruch 1, dadurch gekennzeichnet, daß R und R' Alkyl oder Alkenyl mit jeweils 1 bis 4 Kohlenstoffatomen oder gegebenenfalls substituiertes Phenyl und Hal Chlor oder Brom bedeuten.

3. Verfahren nach Ansprüchen 1 oder 2, dadurch gekennzeichnet, daß die Phosphoniumverbindung Tetramethylphosphoniumchlorid oder Tetrabutylphosphoniumbromid darstellt.

4. Verfahren nach Ansprüchen 1 oder 2, dadurch gekennzeichnet, daß die Phosphoniumverbindung Tetraphenylphosphoniumbromid ist.

5. Verfahren nach Ansprüchen 1 bis 4, dadurch gekennzeichnet, daß die lichtempfindliche Schicht 1 bis 50 Gewichtsprozent an quartärer Phosphoniumverbindung, bezogen auf ihre nichtflüchtigen Bestandteile, enthält.

6. Verfahren nach Anspruch 1, dadurch gekennzeichnet, daß man das bildmäßig belichtete Material auf eine Temperatur im Bereich von 70 bis 150 °C erwärmt.

7. Verfahren nach Ansprüchen 1 und 6, dadurch gekennzeichnet, daß man das Material 10 Sekunden bis 10 Minuten erwärmt.

8. Verfahren nach Anspruch 1, dadurch gekennzeichnet, daß das Material ein wasserunlösliches, in wäßrigalkalischen Lösungen lösliches Bindemittel enthält.

9. Verfahren nach Ansprüchen 1 und 8, dadurch gekennzeichnet, daß das Bindemittel ein Novolak ist.

10. Verfahren nach Anspruch 1, dadurch gekennzeichnet, daß die lichtempfindliche Schicht als 1,2-Chinondiazid einen Ester oder ein Amid einer 1,2-Chinondiazid-4-sulfonsäure oder -4-carbonsäure enthält.

11. Verfahren nach Ansprüchen 1 und 10, dadurch gekennzeichnet, daß die lichtempfindliche Schicht 3 bis 50 Gewichtsprozent an 1,2-Chinondiazidverbindungen, bezogen auf ihre nichtflüchtigen Bestandteile, enthält.

**Claims**

1. Process for producing negative relief copies, by imagewise exposing a light-sensitive material comprising a support and a light-sensitive layer which includes as the essential constituents a compound which promotes thermal curing and a 1,2-quinone diazide, thereafter heating the material and, after cooling, subjecting the material again to an overall exposure, and then developing it by means of an aqueous-alkaline developer, wherein the light-sensitive layer contains, as the compound which promotes thermal curing, at least one quaternary phosphonium compound of the general formula

$$\left[(R)_3-\overset{+}{P}-R'\right] Hal^-$$

in which R and R' are identical or different and denote alkyl, alkenyl or aryl and Hal denotes a halogen.

2. A process as claimed in Claim 1, wherein R and R' denote alkyl or alkenyl having 1 to 4 carbon atoms each or unsubstituted or substituted phenyl and Hal denotes chlorine or bromine.

3. A process as claimed in Claim 1 or 2, wherein the phosphonium compound is tetramethylphosphonium chloride or tetrabutylphosphonium bromide.

4. A process as claimed in Claim 1 or 2, wherein the phosphonium compound is tetraphenylphosphonium bromide.

5. A process as claimed in Claims 1 to 4, wherein the light-sensitive layer contains 1 to 50 percent by weight of a quaternary phosphonium compound, relative to the non-volatile layer constituents.

6. A process as claimed in Claim 1, wherein the material which has been exposed imagewise is heated to a temperature in the range from 70 to 150 °C.

7. A process as claimed in Claims 1 and 6, wherein the material is heated for a period of time ranging from 10 seconds to 10 minutes.

8. A process as claimed in Claim 1, wherein the material contains a binder which is insoluble in water and soluble in aqueous-alkaline solutions.

9. A process as claimed in Claims 1 and 8, wherein the binder used is a novolak.

10. A process as claimed in Claim 1, wherein the light-sensitive layer contains as the 1,2-quinone diazide an ester or an amide of a 1,2-quinone-diazide-4-sulfonic acid or of a 1,2-quinone-diazide-4-carboxylic acid.

11. A process as claimed in Claims 1 and 10, wherein the light-sensitive layer contains from 3 to 50 percent by weight of 1,2-quinone diazide compounds, relative to the non-volatile layer constituents.

**Revendications**

1. Procédé pour l'obtention de copies en relief négatives, dans lequel on expose selon une image un matériau photosensible constitué d'un support de couche et d'une couche photosensible qui contient en tant que composants essentiels un composé accélérant le durcissement thermique et un 1,2-quinonediazide, puis on le chauffe, après refroidissement on l'expose encore une fois sur toute la surface, et on le développe ensuite au moyen d'une solution aqueuse-alcaline de développement, caractérisé en ce que la couche photosensible contient, en tant que composé accélérant le durcissement thermique, au moins un composé de phosphonium quaternaire, de formule générale

$$[(R)_3-\overset{+}{P}-R']Hal^-$$

dans laquelle R et R' sont identiques ou différents et représentent un groupe alkyle, alcényle ou aryle et Hal représente un halogène.

2. Procédé selon la revendication 1, caractérisé en ce que R et R' représentent un groupe alkyle ou alcényle ayant chacun de 1 à 4 atomes de carbone, ou un groupe phényle éventuellement substitué et Hal représente le chlore ou le brome.

3. Procédé selon la revendication 1 ou 2, caractérisé en ce que le composé de phosphonium représente le chlorure de tétraméthylphosphonium ou le bromure de tétrabutylphosphonium.

4. Procédé selon la revendication 1 ou 2, caractérisé en ce que le composé de phosphonium est le bromure de tétraphénylphosphonium.

5. Procédé selon les revendications 1 à 4, caractérisé en ce que la couche photosensible contient de 1 à 50 % en poids de composé de phosphonium quaternaire, par rapport à ses composants non volatils.

6. Procédé selon la revendication 1, caractérisé en ce que l'on chauffe à une température dans la plage de 70 à 150 °C le matériau exposé selon une image.

7. Procédé selon les revendications 1 et 6, caractérisé en ce que l'on chauffe le matériau pendant 10 secondes à 10 minutes.

8. Procédé selon la revendication 1, caractérisé en ce que le matériau contient un liant insoluble dans l'eau, soluble dans des solutions aqueuses-alcalines.

9. Procédé selon les revendications 1 et 8, caractérisé en ce que le liant est une Novolaque.

10. Procédé selon la revendication 1, caractérisé en ce que la couche photosensible contient, en tant que 1,2-quinonediazide, un ester ou un amide d'un acide 1,2-quinonediazide-4-sulfonique ou -4-carboxylique.

11. Procédé selon les revendications 1 et 10, caractérisé en ce que la couche photosensible contient de 3

à 50 % en poids de composés 1,2-quinonediazide, par rapport à ses composants non volatils.